# EUROPEAN PATENT SPECIFICATION

(11) **EP 3 772 153 B1**
(45) Date of publication and mention of the grant of the patent: **09.11.2022**
(21) Application number: 20184232.5
(22) Date of filing: 06.07.2020
(51) Int. Cl.: H02J 7/00, H01M 10/42, H01M 10/48

(54) **BATTERY PROTECTION SYSTEM**
BATTERIESCHUTZSYSTEM
SYSTÈME DE PROTECTION DE BATTERIE

(30) Priority: 30.07.2019 CN 201910696256
(43) Date of publication of application: 03.02.2021
(73) Proprietor: O2Micro, Inc., Santa Clara, CA 95054 (US)
(72) Inventor: ZHANG, Yingguo, Wuhan (CN); Li, Guoxing, Sunnyvale, CA 94089 (US); LIU, Quanwang, Chengdu, 610041 (CN)
(74) Representative: Lippert Stachow Patentanwälte Rechtsanwälte

(56) References cited:
- US-A1- 2016 094 065
- US-A1- 2018 262 023

## Description

### BACKGROUND

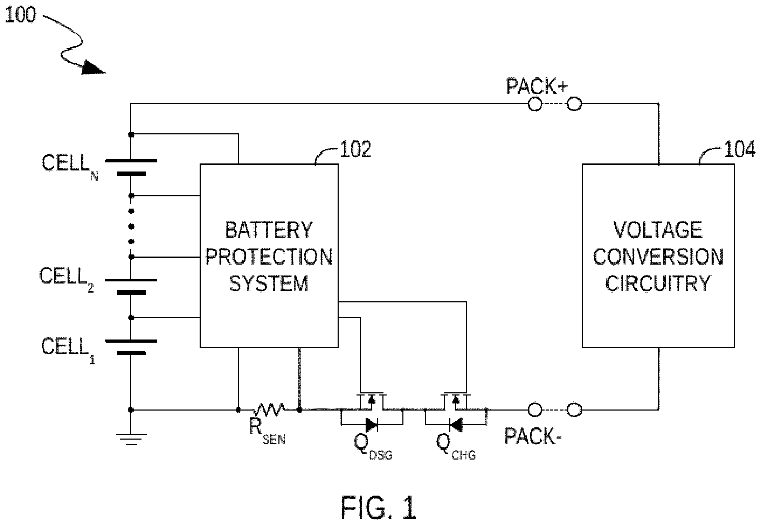

FIG. 1 illustrates a circuit diagram of a conventional battery pack 100. The battery pack 100 includes multiple rechargeable battery cells CELL₁-CELL_{N} (N is a natural number greater than 1), and can be used, in an electronic mobile device, for powering a system load (not shown) having a higher operating voltage. The battery pack 100 also includes a battery protection system 102 for providing protection to the battery cells CELL₁-CELL_{N}. For example, if the battery protection system 102 detects that an over-voltage condition, an under-voltage condition, or an over-current condition is present in the battery cell CELL₁-CELL_{N}, then the battery protection system 102 protects the battery cell CELL₁-CELL_{N} by turning off a charge switch Q_{CHG} and a discharge switch Q_{DSG}.

Due to development of technology, applications of mobile devices are more and more flexible, and specifications of battery chargers (e.g., adapters) are also more and more diversified. For example, a mobile device may have multiple operation modes. In one of the operation modes, an operating voltage of a system load in the mobile device is higher. In another operation mode (hereinafter, a lower power consumption mode), the operating voltage of the system load is lower. Thus, a voltage conversion circuit 104 (e.g., including a buck converter circuit) is included in the mobile device, so that when the mobile device operates in the lower power consumption mode, the voltage conversion circuit 104 can convert a voltage across the battery cells CELL₁-CELL_{N} to a lower voltage level to power the system load. For another example, some chargers have higher output voltages, while others have lower output voltages. In order to improve compatibility so that the battery in the mobile device can be charged by not only a charger with a higher output voltage but also a charger with a lower output voltage, the voltage conversion circuit 104 further includes a boost converter circuit for converting the lower output voltage from the charger to a higher voltage to charge the battery cells CELL₁-CELL_{N}. The voltage conversion circuit 104 (e.g., including a buck converter circuit and a boost converter circuit) not only increases the size of the printed circuit board, the cost, and the power consumption of the mobile device, but also reduces the power supply efficiency and charging efficiency of the battery pack 100. US 2018/0262023 A1 refers to a battery system comprising multiple battery packs wherein each battery pack of the battery system includes a battery, a voltage sense circuity, a control circuit, a control switch and a current regulation circuitry. In each battery pack, the voltage sense circuitry senses a battery voltage of the battery and an input voltage of the battery pack. The control circuit is coupled to the sense circuitry and is operable for adjusting a level of a reference signal based on attribute data associated with the battery pack and a difference between the battery voltage and the input voltage. The control switch is operable for passing a battery current flowing through the battery. The current regulation circuitry is coupled to the control circuit and a control switch, and is operable for controlling the control switch to regulate the battery current according to the reference signal. US 2016/094065 A1 refers to a battery protection circuit that protects a rechargeable battery including a plurality of cells connected in parallel including for each of the cells, an overcharging detection part, an over discharge detection part, a charging current limiting part as well as a discharge current limiting part.

Thus, a battery pack that meets the flexibility of application requirements of the mobile device, and that is compatible with multiple types of chargers would be beneficial. Additionally, a battery protection system that protects this kind of battery pack would also be beneficial.

### SUMMARY

In an embodiment, a battery pack comprises a battery protection system protecting the battery pack that includes a first battery and a second battery. The battery protection system includes a first detection circuit, a second detection circuit, a third detection circuit, and a control circuit coupled to the first, second, and third detection circuits. The first detection circuit is configured to detect a status of a first voltage across a current sensing element, and determine whether the first battery is in an abnormal condition according to the first voltage. The current sensing element is coupled between a negative terminal of the battery pack and a negative electrode of the first battery. The second detection circuit is configured to detect a status of a second voltage across a first switch circuit in a first path, and determine whether the first path is in an abnormal condition according to the second voltage. The first path is coupled between a first positive terminal of the battery pack and a connection node being connected to the positive electrode of the first battery and the negative electrode of the second battery. The third detection circuit is configured to detect a status of a third voltage on a second switch circuit in a second path, and determine whether the second battery is in an abnormal condition according to the third voltage. The second path is coupled between a second positive terminal of the battery pack and a positive electrode of the second battery. The control circuit is configured to turn off the first switch circuit and the second switch circuit if the first detection circuit determines that the first battery is in an abnormal condition. The control circuit is also configured to turn off the first switch if the second detection circuit determines that the first path is in an abnormal condition. The control circuit is also configured to turn off the second switch circuit if the third detection circuit determines that the second battery is in an abnormal condition.

The battery pack includes a first battery, a second battery coupled to the first battery, a negative terminal coupled to a negative electrode of the first battery via a current sensing element, a first positive terminal coupled to a connection node of the first battery and the second battery via a first path that comprises a first switch circuit, a second positive terminal coupled to a positive electrode of the second battery via a second path that comprises a second switch circuit, and a battery protection system, coupled to the current sensing element, the first switch circuit and the second switch circuit. The battery protection system is configured to determine whether the first battery is in an abnormal condition according to a first voltage on the current sensing element, and turn off the first switch circuit and the second switch circuit if an abnormal condition is detected in the first battery. The battery protection system is also configured to determine whether the first path is in an abnormal condition according to a second voltage on the first switch circuit, and turn off the first switch circuit if an abnormal condition is detected in the first path. The battery protection system is also configured to determine whether the second battery is in an abnormal condition according to a third voltage on the second switch circuit, and turn off the second switch circuit if an abnormal condition is detected in the second battery.

Further, in the battery pack, the second switch circuit may be configured to allow a discharging current of the second battery to flow through when the second switch circuit is turned on, and the first switch circuit may be configured to allow a charging current of the first battery and the discharging current of the second battery to flow through when the first switch circuit is turned on. The second voltage may be indicative of a sum of the discharging current and the charging current.

Further, in the battery pack, the second switch circuit may be configured to allow a charging current of the second battery to flow through when the second switch circuit is turned on, and the first switch circuit may be configured to allow a discharging current of the first battery and the charging current of the second battery to flow through when the first switch circuit is turned on. The second voltage may be indicative of a sum of the charging current and the discharging current.

Further, in the battery pack, the battery protection system may be configured to compare the second voltage with a preset reference. If the second voltage is greater than the preset reference for a time interval that is greater than a preset time interval, then the battery protection system may be configured to determine that the first path is in an over-current condition, and configured to turn off the first switch circuit.

Further, in the battery pack, the first switch circuit may be configured to allow a first charging current of the first battery to flow through when the first switch circuit is turned on, and the second switch circuit may be configured to allow a second charging current of the second battery to flow through when the second switch circuit is turned on. The second charging current may also flow through the first battery, and the first voltage may be is indicative of a sum of the first charging current and the second charging current.

Further, in the battery pack, the first switch circuit may be configured to allow a first discharging current of the first battery to flow through when the first switch circuit is turned on, and the second switch circuit may be configured to allow a second discharging current of the second battery to flow through when the second switch circuit is turned on. The second discharging current may also flow through the first battery, and the first voltage may be indicative of a sum of the first discharging current and the second discharging current.

Further, in the battery pack, the battery protection system may be configured to compare the first voltage with a preset reference. If the first voltage is greater than the preset reference for a time interval that is greater than a preset time interval, then the battery protection system may be configured to determine that the first battery is in an over-current condition, and configured to turn off the first switch circuit and the second switch circuit.

Further, in the battery pack, the battery protection system may be configured to detect a status of a battery voltage of the first battery. If an abnormal condition is detected in the battery voltage, then the battery protection system may be configured to turn off the first switch circuit and the second switch circuit.

In yet another embodiment, a method for protecting a battery pack that includes a first battery and a second battery includes multiple steps as follows: detecting, using a detection circuit, a status of a first voltage across a current sensing element that is coupled between a negative terminal of the battery pack and a negative electrode of the first battery; determining whether the first battery is in an abnormal condition according to the first voltage; detecting a status of a second voltage across a first switch circuit in a first path that is coupled between a first positive terminal of the battery pack and a connection node being connected to the positive electrode of the first battery and the negative electrode of the second battery; determining whether the first path is in an abnormal condition according to the second voltage; detecting a status of a third voltage on a second switch circuit in a second path that is coupled between a second positive terminal of the battery pack and a positive electrode of the second battery; determining whether the second battery is in an abnormal condition according to the third voltage; and controlling, using a control circuit coupled to the detection circuit, the first switch circuit and the second switch circuit. Wherein the controlling of the first and second switch circuits includes: turning off the first switch circuit and the second switch circuit if an abnormal condition is detected in the first battery; turning off the first path if an abnormal condition is detected in the first path; and turning off the second switch circuit if an abnormal condition is detected in the second battery.

### BRIEF DESCRIPTION OF THE DRAWINGS

Features and advantages of embodiments of the claimed subject matter will become apparent as the following detailed description proceeds, and upon reference to the drawings, wherein like numerals depict like parts, and in which:
FIG. 1 illustrates a circuit diagram of a conventional battery pack.
FIG. 2 illustrates a circuit diagram of an example of a battery pack with a battery protection system, in an embodiment according to the present invention.
FIG. 3 illustrates examples of current flows in a battery pack corresponding to different operation modes, in embodiments of the present invention.
FIG. 4 illustrates a circuit diagram of an example of a battery protection system in a battery pack, in an embodiment according to the present invention.
FIG. 5 illustrates a circuit diagram of an example of a battery protection system in a battery pack, in an embodiment according to the present invention.
FIG. 6 illustrates a circuit diagram of an example of a battery protection system in a battery pack, in an embodiment according to the present invention.
FIG. 7 illustrates a circuit diagram of an example of a battery pack with a battery protection system, in an embodiment according to the present invention.
FIG. 8 illustrates an example of a method for protecting batteries, in an embodiment of the present invention.

### DETAILED DESCRIPTION

Reference will now be made in detail to the embodiments of the present invention. While the invention will be described in conjunction with these embodiments, it will be understood that they are not intended to limit the invention to these embodiments. On the contrary, the invention is intended to cover alternatives, modifications and equivalents, whichare covered by the appended claims.

Embodiments of the present invention provide a battery pack with a battery protection system. The battery pack includes multiple batteries (or multiple sets of battery cells) coupled in series. Each battery includes one or more battery cells. The battery pack also includes multiple current paths and multiple positive terminals. Each of the positive terminals is coupled to a positive electrode of a corresponding battery of the batteries through a corresponding current path of the current paths. The battery pack also includes a negative terminal that is coupled to the negative electrode of the bottom battery of the batteries through a current sensing element. Because the multiple current paths in the battery pack can be controlled in multiple ways, the battery pack has multiple operation modes. Thus, the battery pack can meet multiple different application requirements of a mobile device, and can be compatible with multiple types of chargers (or adapters) with different specifications. The battery protection system determines whether the battery pack is in an abnormal condition by detecting a status of a current through the current sensing element and statues of currents through the multiple current paths, and/or detecting a status of a voltage of each battery of the multiple batteries. If the battery protection system determines that the battery pack is in an abnormal condition, it controls (e.g., turns off) a corresponding current path to provide protection to the battery pack.

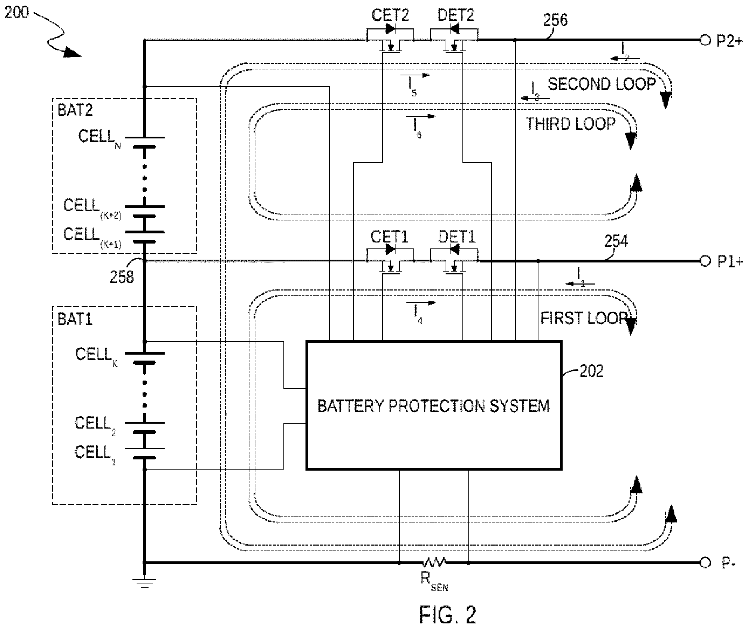

FIG. 2 illustrates a circuit diagram of an example of a battery pack 200 with a battery protection system 202, in an embodiment according to the present invention. The battery pack 200 includes a set of rechargeable battery cells CELL₁-CELL_{N} (N is a natural number greater than 1). In an embodiment, the battery cells CELL₁-CELL_{N} include, but are not limited to, lithium ion batteries. In other embodiments, the battery cells CELL₁-CELL_{N} can include, but are not limited to, lithium polymer batteries, nickel-cadmium batteries, nickel-metal hydride batteries, lithium iron phosphate batteries, or lead-acid batteries. As shown in FIG. 2, the battery cells CELL₁-CELL_{N} are divided into two groups BAT1 and BAT2. The first group of battery cells BAT1 (hereinafter, first battery BAT1) include battery cells CELL₁-CELL_{K}. The second group of battery cells BAT2 (hereinafter, second battery BAT2) include battery cells CELL_{(K+1)}-CELL_{N}. K is a natural number that is greater than or equal to 1 and is less than N. In other words, the first battery BAT1 includes one or more battery cells CELL₁-CELL_{K}, and the second battery BAT2 includes one or more battery cells CELL_{(K+1)}-CELL_{N}. The numbers of battery cells in the first battery BAT1 and that in the second battery BAT2 can be the same or different.

In the example of FIG. 2, the battery pack 200 includes a negative terminal P-, a first positive terminal P1+, a second positive terminal P2+, a current sensing element R_{SEN} (e.g., a sense resistor), a first path 254, and a second path 256. The negative terminal P- is coupled to the negative electrode of the first battery BAT1 (e.g., the negative electrode of the battery cell CELL₁) via the current sensing element R_{SEN}. The first positive terminal P1+ is coupled to the connection node 258 of the first battery BAT1 and the second battery BAT2 via the first path 254. The second positive terminal P2+ is coupled to the positive electrode of the second battery BAT2 (e.g., the positive electrode of the battery cell CELL_{N}) via the second path 256. Additionally, the first path 254 includes a first switch circuit having a first charge switch CET1 and a first discharge switch DET1. The first switch can be referred to as switch circuit CET1-DET. The second path 256 includes a second switch circuit having a second charge switch CET2 and a second discharge switch DET2. The second switch circuit can be referred to as switch circuit CET2-DET2. The battery protection system 202 detects statuses of the batteries BAT1 and BAT2 to determine whether an abnormal condition is present, and protects the battery pack 200 by controlling the first path 254 and the second path 256 according to the detection result. In an embodiment, the statuses of the batteries BAT1 and BAT2 can include, but are not limited to, a charging current, a discharging current, a battery voltage, etc.

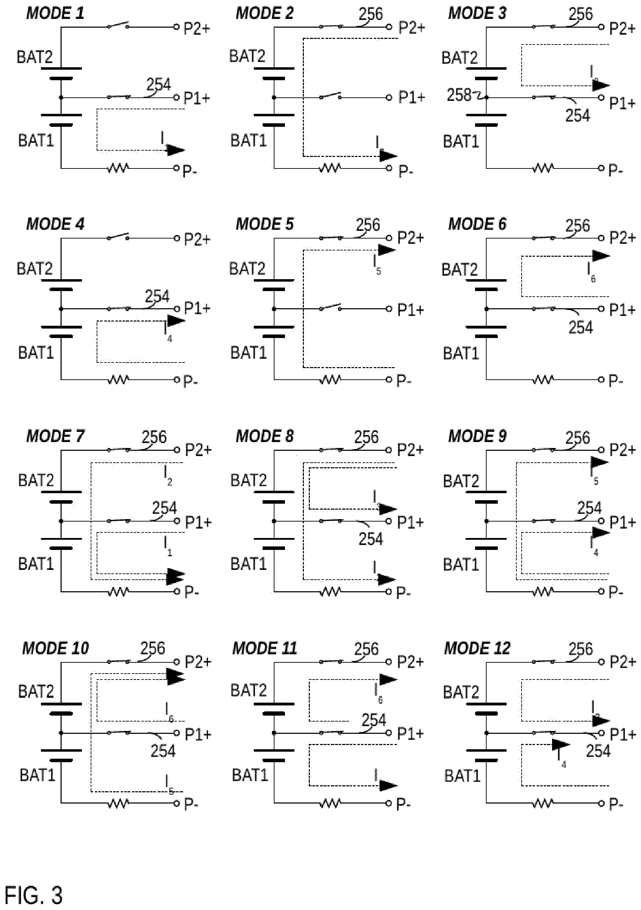

Moreover, as shown in FIG. 2, current loops in the battery pack 200 include a first loop, a second loop, and a third loop, and the battery pack 200 has multiple operation modes. Thus, compared to the conventional battery pack 100, the battery pack 200 in an embodiment of the present invention can meet more application requirements in a mobile device, and can be compatible with more types of chargers (or adapters) with different specifications. Examples of current flows in the battery pack 200 corresponding to different operation modes are illustrated in FIG. 3, in embodiments of the present invention. FIG. 3 is described in combination with FIG. 2.

As shown in FIG. 3, in the first mode (or mode 1), a charger with a lower output voltage (not shown) can be coupled to the first positive terminal P1+ and the negative terminal P-, and can charge the first battery BAT1 through the first loop. A first charging current I₁ can flow to the first battery BAT1 through the first positive terminal P1+ and the first path 254. In the second mode (or mode 2), a charger with a higher output voltage (not shown) can be coupled to the second positive terminal P2+ and the negative terminal P-, and can charge the second battery BAT2 and the first battery BAT1 through the second loop. A second charging current I₂ can flow to the second battery BAT2 and the first battery BAT1 through the second positive terminal P2+ and the second path 256. In the third mode (or mode 3), the second battery BAT2 can be charged through the third loop, and a third charging current I₃ flows to the second battery BAT2 through the second positive terminal P2+ and the second path 256, and flows out from the connection node 258 to the first positive terminal P1+ through the first path 254. Thus, the battery pack 200 can be compatible with multiple types of chargers (or adapters) of different specifications.

Similarly, in the fourth mode (or mode 4), a load with a lower operating voltage (not shown) can be coupled to the first positive terminal P1+ and the negative terminal P-, and the first battery BAT1 can supply power to the load through the first loop. A first discharging current I₄ can flow to the load through the first path and the first positive terminal P1+. In the fifth mode (or mode 5), a load with a higher operating voltage (not shown) can be coupled to the second positive terminal P2+ and the negative terminal P-, and the first battery BAT1 and the second battery BAT2 can supply power to the load through the second loop. A second discharging current I₅ can flow to the load through the second path 256 and the second positive terminal P2+. In the sixth mode (or mode 6), a load with a lower operating voltage (not shown) can be coupled to the second positive terminal P2+ and the first positive terminal P1+, and the second battery BAT2 can supply power to the load through the third loop. A third discharging current I₆ can flow in to the battery pack 200 through the first positive terminal P1+ and the first path, and flow out from the battery pack 200 through the second path and the second positive terminal P2+. Thus, the battery pack 200 can supply power to the loads with different operating voltages.

Additionally, the operation modes of the battery pack 200 also include multiple hybrid modes. For example, in the eighth mode (or mode 8), a charger can charge the batteries BAT1 and BAT2 through the second positive terminal P2+, and a current I₃ can flow out from the battery pack 200 through the first path 254 and the first positive terminal P1+. In an embodiment, the current I₃ can be used to power a load coupled to the first positive terminal P1+ and the negative terminal P-. In another embodiment, the current I₃ can be used as a balancing current of the battery BAT1 to balance the batteries BAT1 and BAT2. The hybrid modes shown in FIG. 3 (e.g., including modes 7 to 12) can meet multiple different application requirements for electronic mobile devices.

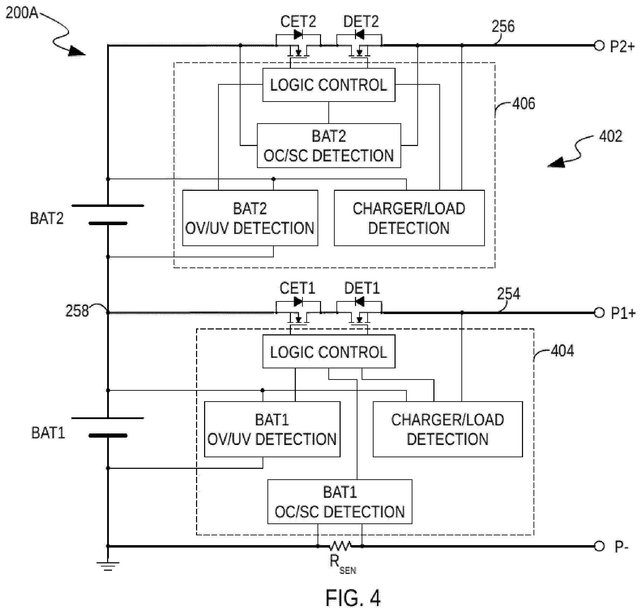

FIG. 4 illustrates a circuit diagram of an example of a battery protection system 402 in a battery pack 200A, in an embodiment according to the present invention. FIG. 4 is described in combination with FIG. 2 and FIG. 3. As shown in FIG. 4, the battery protection system 402 includes a first protection module 404 and a second protection module 406. The first protection module 404 detects statuses (e.g., including a charging current, a discharging current, a battery voltage, etc.) of the battery BAT1 in the first loop, and provides protection to the battery BAT1 according to the detection result. For example, if the first protection module 404 detects that the battery BAT1 is in an abnormal condition (e.g., an over-current condition, an over-voltage condition, or an under-voltage condition), then the switches CET1 and DET1 are turned off. Similarly, the second protection module 406 detects statues of the battery BAT2 in the third loop, and provides protection to the battery BAT2 according to the detection result. If the second protection module 406 detects that the battery BAT2 is in an abnormal condition, then the switches CET2 and DET2 are turned off.

Accordingly, when the battery pack 200A operates in any mode of the modes 1-6, 8, and 10 shown in FIG. 3, the battery protection system 402 can provide protection to the batteries BAT1 and BAT2. However, in an embodiment, the battery pack 200A may operate in the mode 7 shown in FIG. 3. In the mode 7, when the first protection module 404 detects that the battery BAT1 is in an over-voltage condition, the first protection module 404 turns off the switches CET1 and DET1 to disable the first charging current I₁. However, the second charging current I₂ can still charge the over-voltage battery BAT1, and therefore may damage the battery BAT1. Similarly, in another embodiment, the battery pack 200A may operate in the mode 9. In the mode 9, when the first protection module 404 detects that the battery BAT1 is in an under-voltage condition, the first protection module 404 turns off the switches CET1 and DET1 to disable the first discharging current I₄. However, the second discharging current I₅ can still discharge the under-voltage battery BAT1, and therefore may damage the battery BAT1. In yet another embodiment, the battery pack 200A may operate in the mode 11. In the mode 11, the current through the first path 254 is the sum of the charging current I₁ of the battery BAT1 and the discharging current I₆ of the battery BAT2. If the first protection module 404 detects that the battery BAT1 is in a normal condition (e.g., the charging current I₁ is less than a charging over-current threshold of the battery BAT1), then the first protection module 404 keeps the switches CET1 and DET1 on. Similarly, the second protection module 406 can keep the switches CET2 and DET2 on if no abnormal condition in the battery BAT2 is detected (e.g., the discharging current I₅ is less than a discharging over-current threshold of the battery BAT2). However, even if the currents Ii and I₆ are less than their corresponding over-current thresholds, the current through the first path 254 (e.g., the sum of the currents I₁ and I₆) can be relatively large, which may cause damage to the switch circuit CET1-DET1. The relatively large current I₁+I₆ flowing through the switch circuit CET1-DET1 may further cause plenty of heat that damages the battery pack 200A. Similarly, in yet another embodiment, the battery pack 200A may operate in the mode 12. In the mode 12, the current through the first path 254 is the sum of the discharging current I₄ of the battery BAT1 and the charging current I3 of the battery BAT2. Even if the currents I₃ and I₄ are less than their corresponding over-current thresholds, the current I₃+I₄ through the first path 254 can be relatively large, which causes damage to the switch circuit CET1-DET1 and/or the battery pack 200A. Thus, the battery protection system 402 may not be applicable to the modes 7, 9, 11 and 12.

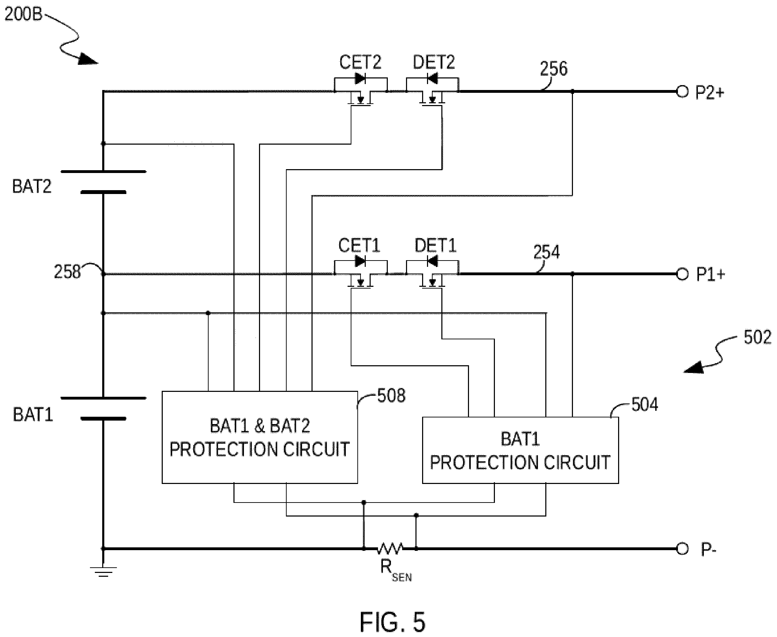

FIG. 5 illustrates a circuit diagram of an example of a battery protection system 502 in a battery pack 200B, in an embodiment according to the present invention. FIG. 5 is described in combination with FIG. 2 and FIG. 3. As shown in FIG. 5, the battery protection system 502 includes a first protection module 504 and a second protection module 506. The first protection module 504 detects statuses (e.g., including a charging current, a discharging current, a battery voltage, etc.) of the battery BAT1 in the first loop, and provides protection to the battery BAT1 according to the detection result. For example, if the first protection module 504 detects that the battery BAT1 is in an abnormal condition (e.g., an over-current condition, an over-voltage condition, or an under-voltage condition), then the switches CET1 and DET1 are turned off. The second protection module 506 detects statuses of the battery BAT1 and battery BAT2 in the second loop, and provides protection to the batteries BAT1 and BAT2 according to the detection result. The statuses of the batteries BAT1 and BAT2 can include, but are not limited, their corresponding charging currents, discharging currents, battery voltages, etc. If the second protection module 506 detects that an abnormal condition is present in the battery BAT1 or the battery BAT2, then the switches CET2 and DET2 are turned off.

Accordingly, when the battery pack 200B operates in any mode of the modes 1-10 shown in FIG. 3, the battery protection system 502 can provide protection to the batteries BAT1 and BAT2. However, similar to the battery pack 200A in FIG. 4, if the battery pack 200B in FIG. 5 operates in the mode 11 or mode 12, the current through the first path 254 (e.g., the sum of currents I₁ and I₆, or the sum of currents I₃ and I₄) can be relatively large, which may cause damage to the switch circuit CET1-DET1 and/or the battery pack 200B. Thus, the battery protection system 502 may not be applicable to the modes 11 and 12.

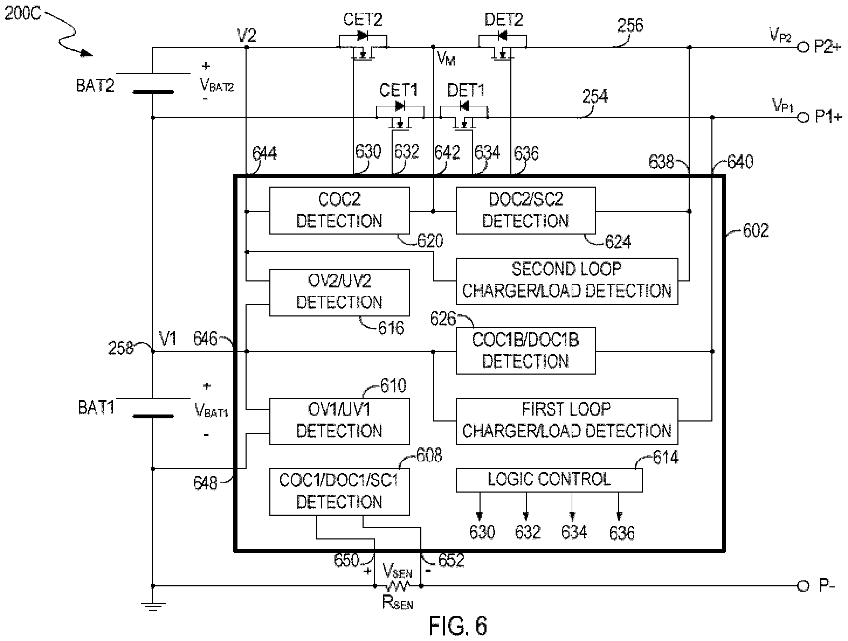

FIG. 6 illustrates a circuit diagram of an example of a battery protection system 602 in a battery pack 200C, in an embodiment according to the present invention. Advantageously, the battery protection system 602 in the embodiment of FIG. 6 can provide protection to the battery pack 200C when the battery pack 200C operates in any mode of modes 1-12. Compared to the battery protection system 402 in FIG. 4 and the battery protection system 502 in FIG. 5, the battery protection system 602 in FIG. 6 can provide more comprehensive protection to the battery pack 200C. FIG. 6 is described in combination with FIG. 2 and FIG. 3.

As shown in FIG. 6, the battery protection system 602 includes detection terminals 638, 640, 642, 644, 646, 648, 650, and 652, operable for detecting statuses of the battery pack 200C. For example, the statuses of the battery pack 200C can include, but are not limited to, a current of the battery BAT1, a voltage of the battery BAT1, a current of the battery BAT2, a voltage of the battery BAT2, and a current through the first path 254. The battery protection system 602 further includes control terminals 630, 632, 634, and 636, operable for controlling (e.g., turning on or off) the switches CET2, CET1, DET1 and DET2.

More specifically, as shown in FIG. 6, the detection terminals 650 and 652 are coupled to the current sensing element R_{SEN}, and are configured to receive a voltage V_{SEN} (hereinafter, first voltage V_{SEN}) on the current sensing element R_{SEN} that is indicative of a current through the current sensing element R_{SEN}. The detection terminals 646 and 648 are respectively coupled to the positive electrode and the negative electrode of the first battery BAT1, and are configured to receive a battery voltage V_{BAT1} of the battery BAT1. The detection terminals 644 and 646 are respectively coupled to the positive electrode and the negative electrode of the second battery BAT2, and are configured to receive a battery voltage V_{BAT2} of the battery BAT2.

The detection terminals 638, 642, and 644 are configured to receive a voltage on the second switch circuit CET2-DET2 (hereinafter, a third voltage). The third voltage can include, but is not limited to, V_{M}-V2, V_{M}-V_{P2}, V_{P2}-V2, or V2-V_{P2}. More specifically, in the example of FIG. 6, the charge switch CET2 in the second switch circuit CET2-DET2 includes a transistor (e.g., a metal-oxide-semiconductor field-effect transistor). The transistor CET2 includes a first terminal (e.g., a drain terminal), a second terminal (e.g., a source terminal) and a control terminal (e.g., a gate terminal). The first terminal is coupled to the discharge switch DET2, the second terminal is coupled to the battery BAT2, and the control terminal is coupled to the battery protection system 602. The battery protection system 602 can turn on or off the transistor CET2 by controlling a voltage at the control terminal (e.g., the gate terminal) of the transistor CET2. When the battery protection system 602 turns on the transistor CET2, a charging current of the battery BAT2 can flow from the first terminal to the second terminal through the transistor CET2, and the on-resistance R_{DSON} of the transistor CET2 can be used as a current sensing resistor to generate a voltage V_{M}-V2 indicative of the charging current. V_{M} represents a voltage at the connection node of switches CET2 and DET2, and V2 represents a voltage at the positive electrode of battery BAT2. The detection terminals 642 and 644 are coupled to the first terminal and the second terminal of the transistor CET2, respectively, and are configured to receive the voltage V_{M}-V2. Similarly, the discharge switch DET2 in the second switch circuit CET2-DET2 includes a transistor (e.g., a metal-oxide-semiconductor field-effect transistor). When the transistor DET2 is turned on, the on-resistance of the transistor DET2 can be used as a current sensing resistor to generate a voltage V_{M}-V_{P2} indicative of a discharging current of the battery BAT2. V_{P2} represents a voltage at the second positive terminal P2+. The detection terminals 638 and 642 are coupled to the transistor DET2, and are configured to receive the voltage V_{M}-V_{P2}. In the example of FIG. 6, the battery protection system 602 monitors the charging current of the battery BAT2 by monitoring the voltage drop V_{M}-V2 across the charge switch CET2, and monitors the discharging current of the battery BAT2 by monitoring the voltage drop V_{M}-V_{P2} across the discharge switch DET2. However, the invention is not so limited. In another embodiment, when both the charge switch CET2 and the discharge switch DET2 are turned on, a voltage drop V_{P2}-V2 (or V2-V_{P2}) across the switch circuit CET2-DET2 can also represent a charging current (or a discharging current) of the battery BAT2. Thus, the battery protection system 602 can monitor the voltage difference V_{P2}-V2 between the detection terminals 638 and 644 thereby monitoring the charging current of the battery pack BAT2. The battery protection system 602 can also monitor the voltage different V2-V_{P2} between the detection terminals 644 and 638 thereby monitoring the discharging current of the battery pack BAT2. In one such embodiment, the detection terminal 642 can be omitted.

The detection terminals 640 and 646 are configured to receive a voltage on the first switch circuit CET1-DET1 (hereinafter, second voltage). The second voltage can include, but is not limited to, V_{P1}-V1 or V1-V_{P1}. More specifically, similar to the switches in the second switch circuit CET2-DET2, the charge switch CET1 and the discharge switch DET1 in the first switch circuit CET1-DET1 can include transistors (e.g., metal-oxide-semiconductor field-effect transistors). When both the switches CET1 and DET1 are turned on, a voltage drop V_{P1}-V1 (or V1-V_{P1}) across the switch circuit CET1-DET1 can be indicative of a charging current (or a discharging current) through the first path 254. V1 represents a voltage at the positive electrode of the battery BAT1, and V_{P1} represents a voltage at the first positive terminal P1+. The charging current through the first path 254 refers to a current that flows from the first positive terminal P1+ to the connection node 258 of the batteries BAT1 and BAT2 through the first path 254. The discharging current through the first path 254 refers to a current that flows from the connection node 258 of the batteries BAT1 and BAT2 to the first positive terminal P1+ through the first path 254. Although in the example of FIG. 6, the battery protection system 602 monitors a current through the first path 254 by monitoring a voltage difference between the detection terminals 640 and 646, the invention is not so limited. In another embodiment, the battery protection system 602 can further include a detection terminal (not shown in FIG. 6) coupled to the connection node of the first charge switch CET1 and the first discharge switch DET1. The battery protection system 602 can monitor a charging current through the first path 254 by monitoring a voltage drop V_{CET1} across the charge switch CET1, and monitor a discharging current through the first path 254 by monitoring a voltage drop V_{DET1} across the discharge switch DET1.

The control terminals 630, 632, 634 and 636 are respectively coupled to the control terminals (e.g., gate terminals) of the switches CET2, CET1, DET1 and DET2 (e.g., metal-oxide-semiconductor field-effect transistors) for controlling (e.g., turning on or off) the switches CET2, CET1, DET1 and DET2.

Additionally, as shown in FIG. 6, the battery protection system 602 includes a COC1/DOC1/SC1 current detection circuit 608, a COC1B/DOC1B current detection circuit 626, a COC2 current detection circuit 620, and a DOC2/SC2 current detection circuit 624. As used herein, COC stands for charging over-current, DOC stands for discharging over-current, and SC stands for short-circuit. The COC1/DOC1/SC1 current detection circuit 608 can be referred to as first detection circuit, and configured to detect a status of an abovementioned first voltage V_{SEN} on the current sensing element R_{SEN}, and determine whether the first battery BAT1 is in an abnormal condition (e.g., a charging over-current condition, a discharging over-current condition, or a short-circuit condition) according to the first voltage V_{SEN}. The COC1B/DOC1B current detection circuit 626 can be referred to as second detection circuit, and configured to detect a status of an abovementioned second voltage (e.g., V_{P1}-V1, V1-V_{P1}, V_{CET1} or V_{DET1}) on the first switch circuit CET1-DET1 in the first path 254, and determine whether the first path 254 is in an abnormal condition (e.g., a charging over-current condition or a discharging over-current condition) according to the second voltage. The combined circuit of the COC2 current detection circuit 620 and the DOC2/SC2 current detection 624 circuit can be referred to as third detection circuit, and configured to detect a status of an abovementioned third voltage (e.g., V_{M}-V2, V_{P2}-V2, V_{M}-V_{P2}, or V_{P2}-V_{M}) on the second switch circuit CET2-DET2 in the second path 256, and determine whether the second battery BAT2 is in an abnormal condition (e.g., a charging over-current condition, a discharging over-current condition, or a short-circuit condition) according to the third voltage.

The battery protection system 602 further includes an OV1/UV1 voltage detection circuit 610 and an OV2/UV2 voltage detection circuit 616. As used herein, OV stands for over-voltage, and UV stands for under-voltage. The OV1/UV1 voltage detection circuit 610 can be referred to as fourth detection circuit, and configured to detect a status of a battery voltage V_{BAT1} of the first battery BAT1. The OV2/UV2 voltage detection circuit 616 can be referred to as fifth detection circuit, and configured to detect a status of a battery voltage V_{BAT2} of the second battery BAT2.

The battery protection system 602 further includes a control circuit 614 (e.g., a logic control circuit) coupled to the first detection circuit 608, the second detection circuit 626, the third detection circuit (e.g., including the circuits 620 and 624), the fourth detection circuit 610, and the fifth detection circuit 616. The control circuit 614 is coupled to the control terminals 630, 632, 634, and 636, and can control the first switch circuit CET1-DET1 and the second switch circuit CET2-DET2 according to detection results from the abovementioned detection circuits. More specifically, the control circuit 614 can turn on or off the switches CET2, CET1, DET1 and DET2 through their corresponding control terminals (e.g., gate terminals). For example, the control circuit 614 can turn on or off the switch CET2 by controlling a voltage at the gate terminal of switch CET2. In an embodiment, if the first detection circuit 608 determines that the first battery BAT1 is in an abnormal condition (e.g., an over-current condition, an over-voltage condition, or an under-voltage condition), then the control circuit 614 turns off the first switch circuit CET1-DET1 and the second switch circuit CET2-DET2. If the second detection circuit 626 determines that the first path 254 is in an abnormal condition (e.g., an over-current condition), then the control circuit 614 turns off the first switch circuit CET1-DET1. If the third detection circuit (e.g., including the circuits 620 and 624) determines that the second battery BAT2 is in an abnormal condition (e.g., an over-current condition, an over-voltage condition, or an under-voltage condition), then the control circuit 614 turns off the second switch circuit CET2-DET2. In an embodiment, when the first charge switch CET1 and the first discharge switch DET1 are on, the first switch circuit CET1-DET1 is considered to be on. When the switches CET1 and DET1 are off, the first switch circuit CET1-DET1 is considered to be off. Similarly, when the second charge switch CET2 and the second discharge switch DET2 are turned on, the second switch circuit CET2-DET2 is considered to be on. When the switches CET2 and DET2 are off, the second switch circuit CET2-DET2 is considered to be off.

Accordingly, the battery protection system 602 can provide protection to the battery pack 200C when the battery pack 200C operates in any mode of the modes 1-12. Examples are described as follows in combination with FIG. 3.

When the battery pack 200C operates in the mode 7, the first charge switch CET1 (or the first switch circuit CET1-DET1) is turned on to allow a first charging current (e.g., Ii) of the first battery BAT1 to flow through, and the second charge switch CET2 (or the second switch circuit CET2-DET2) is turned on to allow a second charging current (e.g., I₂) of the second battery BAT2 to flow through. The second charging current I₂ also flows through the first battery BAT1. Thus, in the mode 7, the above-mentioned first voltage (e.g., V_{SEN}) is indicative of the sum of the first charging current I₁ and the second charging current I₂. The first detection circuit 608 can detect a status of the first voltage V_{SEN} by comparing the first voltage V_{SEN} with a preset reference Vcoci (e.g., a voltage reference indicative of a charging over-current threshold of the battery BAT1), and provide a result of the comparison to the control circuit 614. If the first voltage V_{SEN} is greater than the preset reference Voci for a time interval that is greater than a preset time interval, then the control circuit 614 determines that the first battery BAT1 is in a charging over-current condition, and turns off the first switch circuit CET1-CET2 and the second switch circuit CET2-DET2. Additionally, in the mode 7, the fourth detection circuit 610 detects a status of a battery voltage V_{BAT1} of the first battery BAT1 by comparing the battery voltage V_{BAT1} with a preset reference V_{OV1} (e.g., an over-voltage threshold of the battery BAT1), and provides a detection result to the control circuit 614. If the battery voltage V_{BAT1} is greater than the preset reference V_{OV1} for a time interval that is greater than a preset time interval, then the detection result indicates that the batter voltage V_{BAT1} is in an abnormal condition, e.g., the first battery BAT1 is in an over-voltage condition, and the control circuit 614 turns off the first switch circuit CET1-CET2 and the second switch circuit CET2- DET2. Accordingly, the battery protection system 602 can provide protection to the battery pack 200C when it operates in the mode 7.

Similarly, in the mode 9, the first discharge switch DET1 (or the first switch circuit CET1-DET1) is turned on to allow a first discharging current (e.g., I₄) of the first battery BAT1 to flow through. The second discharge switch DET2 (or the second switch circuit CET2-DET2) is also turned on to allow a second discharging current (e.g., I₅) of the second battery BAT2 to flow through. The second discharging current I₅ also flows through the first battery BAT1. Thus, in the mode 9, the above-mentioned first voltage (e.g., -V_{SEN}) is indicative of the sum of the first discharging current I₄ and the second discharging current I₅. The first detection circuit 608 can compare the first voltage -V_{SEN} with a preset reference V_{DOC1} (e.g., a voltage reference indicative of a discharging over-current threshold of the battery BAT1), and provide a result of the comparison to the control circuit 614. If the first voltage -V_{SEN} is greater than the preset reference V_{DOC1} for a time interval that is greater than a preset time interval, then the control circuit 614 determines that the first battery BAT1 is in a discharging over-current condition, and turns off the first switch circuit CET1-CET2 and the second switch circuit CET2-DET2. In addition, in the mode 9, the fourth detection circuit 610 compares a battery voltage V_{BAT1} of the first battery BAT1 with a preset reference V_{UV1} (e.g., an under-voltage threshold of the battery BAT1). If the battery voltage V_{BAT1} is less than the preset reference V_{UV1} for a time interval that is greater than a preset time interval, then the control circuit 614 determines that the first battery BAT1 is in an under-voltage condition, and turns off the first switch circuit CET1-CET2 and the second switch circuit CET2- DET2. Accordingly, the battery protection system 602 can provide protection to the battery pack 200C when it operates in the mode 9.

When the battery pack 200C operates in the mode 11, the second discharge switch DET2 (or the second switch circuit CET2-DET2) is turned on to allow a discharging current (e.g., I₆) of the second battery BAT2 to flow through. The first charge switch CET1 (or the first switch circuit CET1-DET1) is also turned on to allow a charging current (e.g., I₁) of the first battery BAT1 and the discharging current I₆ of the second battery BAT2 to flow through. Thus, an abovementioned second voltage (e.g., V_{P1}-V1) on the first switch circuit CET1-DET1 can be indicative of the sum of the discharging current I₆ and the charging current I₁. The second detection circuit 626 can compare the second voltage V_{P1}-V1 with a preset reference V_{COC2} (e.g., a voltage reference indicative of a charging over-current threshold of the first path 254), and provide a result of the comparison to the control circuit 614. If the second voltage V_{P1}-V1 is greater than the preset reference V_{COC2} for a time interval that is greater than a preset time interval, then the control circuit 614 determines that the first path 254 is in a charging over-current condition, and turns off the first switch circuit CET1-DET1. Accordingly, the battery protection system 602 can provide protection to the battery pack 200C when it operates in the mode 11.

Similarly, in the mode 12, the second charge switch CET2 (or the second switch circuit CET2-DET2) is turned on to allow a charging current (e.g., I₃) of the second battery BAT2 to flow through. The first discharge switch DET1 (or the first switch circuit CET1-DET1) is also turned on to allow a discharging current (e.g., I₄) of the first battery BAT1 and the charging current I₃ of the second battery BAT2 to flow through. Thus, an abovementioned second voltage (e.g., V1-V_{P1}) on the first switch circuit CET1-DET1 can be indicative of the sum of the discharging current I₄ and the charging current I₃. The second detection circuit 626 can compare the second voltage V1-V_{P1} with a preset reference V_{DOC2} (e.g., a voltage reference indicative of a discharging over-current threshold of the first path 254), and provide a result of the comparison to the control circuit 614. If the second voltage V1-V_{P1} is greater than the preset reference V_{DOC2} for a time interval that is greater than a preset time interval, then the control circuit 614 determines that the first path 254 is in a discharging over-current condition, and turns off the first switch circuit CET1-DET1. Accordingly, the battery protection system 602 can provide protection to the battery pack 200C when it is operating in the mode 12.

Moreover, if the battery pack 200C operates in the mode 1 or mode 4, then the battery protection system 602 can protect the battery pack 200C by monitoring the first voltage V_{SEN} and the voltage V_{BAT1} of the first battery BAT1. If the battery pack 200C operates in the mode 2 or mode 5, then the battery protection system 602 can protect the battery pack 200C by monitoring the first voltage V_{SEN} and/or the third voltage (e.g., V_{M}-V2, V_{P2}-V2, V_{M}-V_{P2}, or V_{P2}-V_{M}), and monitoring the voltage V_{BAT1} of the first battery BAT1 and the voltage V_{BAT2} of the second battery BAT2. If the battery pack 200C operates in the mode 3 or mode 6, then the battery protection system 602 can protect the battery pack 200C by monitoring the third voltage (e.g., V_{M}-V2, V_{P2}-V2, V_{M}-V_{P2}, or V_{P2}-V_{M}) and the voltage V_{BAT2} of the second battery BAT2. If the battery pack 200C operates in the mode 8 or mode 10, then the battery protection system 602 can protect the battery pack 200C by monitoring the third voltage (e.g., V_{M}-V2, V_{P2}-V2, V_{M}-V_{P2}, or V_{P2}-V_{M}), and monitoring the voltage V_{BAT1} of the first battery BAT1 and the voltage V_{BAT2} of the second battery BAT2. Accordingly, the battery protection system 602 can provide protection to the battery pack 200C in any mode of modes 1-12.

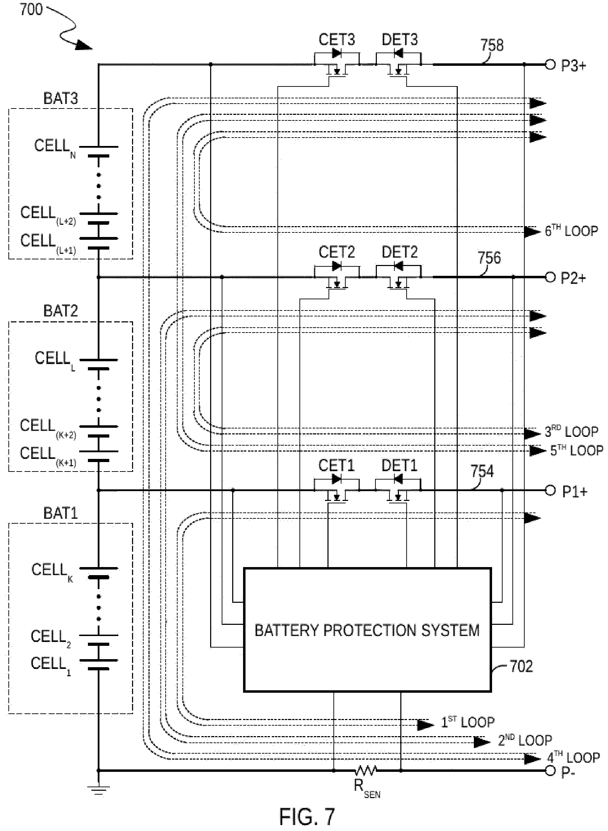

In abovementioned embodiments, the battery pack (e.g., 200, 200A, 200B, or 200C) includes two group of battery cells. However, the invention is not so limited. In other embodiments, the battery pack can include three, four, or more groups of battery cells. A circuit diagram of an example of a battery pack 700 with a battery protection system 702 is illustrated in FIG. 7, in another embodiment according to the present invention. FIG. 7 is described in combination with FIG. 2. FIG. 3 and FIG. 6.

In the example of FIG. 7, the battery cells CELL₁-CELL_{N} in the battery pack 700 are divided into three groups, BAT1, BAT2 and BAT3. The first group BAT1 includes one or more battery cells CELL₁-CELL_{K} (hereinafter, first battery BAT1), the second group BAT2 includes one or more battery cells CELL_{(K+1)}-CELL_{L} (hereinafter, second battery BAT2), and the third group BAT3 includes one or more battery cells CELL_{(L+1)}-CELL_{N} (hereinafter, third battery BAT3). K is a natural number that is greater than or equal to 1, and L is a natural number that is greater than or equal to K+1. The number of battery cells in the first battery BAT1, the number of battery cells in the second battery BAT2, and the number of battery cells in the third battery BAT3 can be the same or different. Compared to the battery pack 200 shown in FIG. 2, the battery pack 700 in FIG. 7 includes more current loops, e.g., including a 1^{st} loop, a 2^{nd} loop, a 3^{rd} loop, a 4^{th} loop, a 5^{th} loop and a 6^{th} loop, and therefore the battery pack 700 can have more operation modes.

As shown in FIG. 7, the battery pack 700 includes a negative terminal P-, a first positive terminal P1+, a second positive terminal P2+, and a third positive terminal P3+. The battery pack 700 further includes a current sensing element R_{SEN}, a first path 754, a second path 756, and a third path 758. Similar to the battery protection system 602 in FIG. 6, the battery protection system 702 can determine whether an over-current condition is present in the first battery BAT1, the second battery BAT2, the third battery BAT3, the first path 754, and/or the second path 756 by monitoring voltages on the current sensing element R_{SEN}, the first path 754, the second path 756, and/or the third path 758. Additionally, in an embodiment, the battery protection system 702 further includes a battery current detection element or circuit (not shown in FIG. 7), coupled to the second battery BAT2, that monitors a charging current or discharging current of the second battery BAT2 thereby determining whether an over-current condition is present in the second battery BAT2. Moreover, the battery protection system 702 determines whether an over-voltage condition or under-voltage condition is present in the battery BAT1, the battery BAT2 and the battery BAT3 by monitoring battery voltages of the batteries BAT1, BAT2, and BAT3. If the battery protection system 702 determines that the first battery BAT1 is in an abnormal condition (e.g., an over-current condition, an over-voltage condition, or an under-voltage condition), then the first switch circuit CET1-DET1, the second switch circuit CET2-DET2, and the third switch circuit CET3-DET3 are turned off. If the battery protection system 702 determines that the second battery BAT2 is in an abnormal condition (e.g., an over-current condition, an over-voltage condition, or an under-voltage condition), then the second switch circuit CET2-DET2 and the third switch circuit CET3-DET3 are turned off. If the battery protection system 702 determines that the third battery BAT3 is in an abnormal condition (e.g., an over-current condition, an over-voltage condition, or an under-voltage condition), then the third switch circuit CET3-DET3 is turned off. If the battery protection system 702 determines that the first path 754 is in an abnormal condition (e.g., an over-current condition), then the first switch circuit CET1-DET1 is turned off. If the battery protection system 702 determines that the second path 756 is in an abnormal condition (e.g., an over-current condition), then the second switch circuit CET2-DET2 is turned off. Similar to the battery pack 200 in FIG. 2, the battery pack 700 has multiple operation modes. For example, if the charge switches CET1, CET2, and CET3 are turned on, three charging currents can flow into the battery pack 700 through the positive terminals P1+, P2+, and P3+, respectively, and charge the battery BAT1. For another example, if the charge switches CET1 and CET2 are turned on and the discharge switch DET3 is turned on, then two charging currents can flow into the battery pack 700 through the positive terminals P1+ and P2+, and a discharging current can flow out of the battery pack 700 through the positive terminal P3+. Advantageously, the battery protection system 702 can provide protection to the battery pack 700 in any mode of the multiple operation modes.

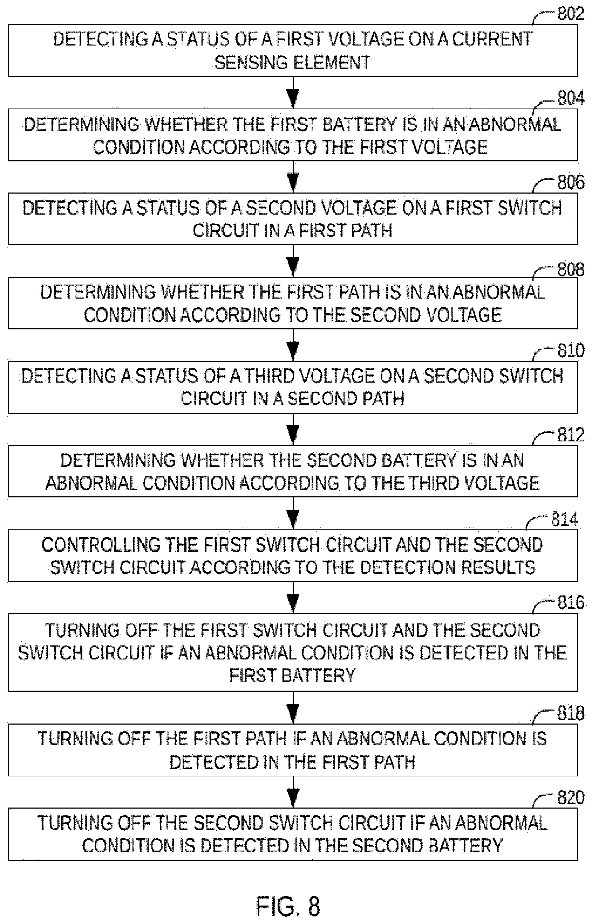

FIG. 8 illustrates an example of a method for protecting batteries, in an embodiment of the present invention. FIG. 8 is described in combination with FIG. 2, FIG. 3, FIG. 6 and FIG. 7. Although specific steps are disclosed in FIG. 8, such steps are examples for illustrative purposes. That is, embodiments according to the present invention are well suited to performing various other steps or variations of the steps recited in FIG. 8.

At step 802, the first detection circuit 608 detects a status of the first voltage V_{SEN} on the current sensing element R_{SEN} that is coupled between the negative terminal P- of the battery pack 200C and the negative electrode of the first battery BAT1.

At step 804, the control circuit 614 determines whether the first battery BAT1 is in an abnormal condition according to the first voltage V_{SEN}.

At step 806, the second detection circuit 626 detects a status of a second voltage (e.g., V_{P1}-V1, V1-V_{P1}, VCET1, or V_{DET1}) on a first switch circuit CET1-DET1 in the first path 254 that is coupled between the first positive terminal P1+ of the battery pack 200C and the connection node of the first battery BAT1 and the second battery BAT2.

At step 808, the control circuit 614 determines whether the first path 254 is abnormal according to the second voltage.

At step 810, a third detection circuit (e.g., including the circuits 620 and 624) detects a status of a third voltage (e.g., V_{M}-V2, V_{P2}-V2, V_{M}-V_{P2}, or V_{P2}-V_{M}) on the second switch circuit CET2-DET2 in the second path 256 that is coupled between the second positive terminal P2+ of the battery pack 200C and the positive electrode of the second battery BAT2.

At step 812, the control circuit 614 determines whether the second battery BAT2 is in an abnormal condition according to the third voltage.

At step 814, the control circuit 614 controls the first switch circuit CET1-DET1 and the second switch circuit CET2-DET2 according to the detection results from the first, second and third detection circuits.

More specifically, at step 816, the control circuit 614 turns off the first switch circuit CET1-DET1 and the second switch circuit CET2-DET2 if an abnormal condition is detected in the first battery BAT1.

At step 818, the control circuit 614 turns off the first switch circuit CET1-DET1 if an abnormal condition is detected in the first path 254.

At step 820, the control circuit 614 turns off the second switch circuit CET2-DET2 if an abnormal condition is detected in the second battery BAT2.

While the foregoing description and drawings represent embodiments of the present invention, it will be understood that various additions, modifications and substitutions may be made therein as covered by the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements. The presently disclosed embodiments are therefore to be considered in all respects as illustrative and not restrictive, the scope of the invention being indicated by the appended claims and not limited to the foregoing description.

## Claims

1. A battery pack (200, 200C, 700) comprising a battery protection system (202, 602, 702) for protecting a battery pack (200, 200C, 700) that comprises a first battery (BAT1) and a second battery (BAT2), wherein said battery protection system (202, 602, 702) comprises:
a first detection circuit (608) configured to detect a status of a first voltage (V_{SEN}; -V_{SEN}) across a current sensing element (R_{SEN}), and determine whether said first battery (BAT1) is in an abnormal condition according to said first voltage (V_{SEN}; -V_{SEN}), wherein said current sensing element (R_{SEN}) is coupled between a negative terminal (P-) of said battery pack (200, 200C, 700) and a negative electrode of said first battery (BAT1);
a second detection circuit (626) configured to detect a status of a second voltage (V_{P1}-V1; V1-V_{P1}; V_{CET1}; V_{DET1}) across a first switch circuit (CET1-DET1) in a first path (254), and determine whether said first path (254) is in an abnormal condition according to said second voltage (V_{P1}-V1; V1-V_{P1}; V_{CET1}; V_{DET1}), wherein said first path (254) is coupled between a first positive terminal (P1+) of said battery pack (200, 200C, 700) and a connection node (258) being connected to the positive electrode of the first battery (BAT1) and the negative electrode of the second battery (BAT2);
a third detection circuit (620, 624) configured to detect a status of a third voltage (V_{M}-V2; V_{P2}-V2; V_{M}-V_{P2}; V_{P2}-V_{M}) across a second switch circuit (CET2-DET2) in a second path (256), and
determine whether said second battery (BAT2) is in an abnormal condition according to said third voltage (V_{M}-V2; V_{P2}-V2; V_{M}-V_{P2}; V_{P2}-V_{M}), wherein said second path (256) is coupled between a second positive terminal (P2+) of said battery pack (200, 200C, 700) and a positive electrode of said second battery (BAT2); and
a control circuit (614), coupled to said first detection circuit (608), said second detection circuit (626), and said third detection circuit (620, 624), wherein said control circuit (614) is configured to turn off said first switch circuit (CET1-DET1) and said second switch circuit (CET2-DET2) if said first detection circuit (608) determines that said first battery (BAT1) is in an abnormal condition, configured to turn off said first switch circuit (CET1-DET1) if said second detection (626) circuit determines that said first path (254) is in an abnormal condition, and configured to turn off said second switch circuit (CET2-DET2) if said third detection circuit wherein said battery protection system (202, 602, 702) is coupled to said current sensing element (R_{SEN}), said first switch circuit (CET1-DET1) and said second switch circuit (CET2-DET2).

2. The battery pack (200, 200C, 700) of claim 1, wherein said second switch circuit (CET2-DET2) comprises a transistor (CET2, DET2) having a first terminal (642), a second terminal (644, 638), and a control terminal (630, 636), wherein when said control circuit (614) turns on said transistor (CET2, DET2) by controlling said control terminal (630, 636), a current flows from said first terminal (642) to said second terminal (644, 638) through said transistor (CET2, DET2), and said transistor generates a voltage drop (V_{M}-V2; V_{M}-V_{P2}) between said first terminal (642) and said second terminal (644, 638), and wherein said third voltage (V_{M}-V2; V_{P2}-V2; V_{M}-V_{P2}; V_{P2}-V_{M}) comprises said voltage drop (V_{M}-V2; V_{M}-V_{P2}).

3. The battery pack (200, 200C, 700) of claim 1 or 2, wherein said second switch circuit (CET2-DET2) allows a discharging current (I₆) of said second battery (BAT2) to flow through when said second switch circuit (CET2-DET2) is turned on, and said first switch circuit (CET1-DET1) allows a charging current (I₁) of said first battery (BAT1) and said discharging current (I₆) of said second battery (BAT2) to flow through when said first switch circuit (CET1-determines that said second battery (BAT2) is in an abnormal condition, DET1) is turned on, and wherein said second voltage (V_{P1}-V1; V_{CET1}) is indicative of a sum of said discharging current (I₆) and said charging current (I₁).

4. The battery pack (200, 200C, 700) of claim 1 or 2, wherein said second switch circuit (CET2-DET2) allows a charging current (I₃) of said second battery (BAT2) to flow through when said second switch circuit (CET2-DET2) is turned on, and said first switch circuit (CET1-DET1) allows a discharging current (I₄) of said first battery (BAT1) and said charging current (I₃) of said second battery (BAT2) to flow through when said first switch circuit (CET1-DET1) is turned on, and wherein said second voltage (V1-V_{P1}; V_{DET1}) is indicative of a sum of said charging current (I₃) and said discharging current (I₄).

5. The battery pack (200, 200C, 700) of any of claims 1 to 4, wherein said second detection circuit (626) compares said second voltage (V_{P1}-V1; V1-V_{P1}; V_{CET1}; V_{DET1}) with a preset reference (V_{COC2}; V_{DOC2}), and provides a result of the comparison to said control circuit (614), and wherein if said second voltage (V_{P1}-V1; V1-V_{P1}; V_{CET1}; V_{DET1}) is greater than said preset reference (V_{COC2}; V_{DOC2}) for a time interval that is greater than a preset time interval, then said control circuit (614) determines that said first path (254) is in an over-current condition, and said control circuit (614) turns off said first switch circuit (CET1-DET1).

6. The battery pack (200, 200C, 700) of claim 1 or 2, wherein said first switch circuit (CET1-DET1) allows a first charging current (I₁) of said first battery (BAT1) to flow through when said first switch circuit (CET1-DET1) is turned on, said second switch circuit (CET2-DET2) allows a second charging current (I₂) of said second battery (BAT2) to flow through when said second switch circuit (CET2-DET2) is turned on, wherein said second charging current (I₂) also flows through said first battery (BAT1), and wherein said first voltage (V_{SEN}) is indicative of a sum of said first charging current (I₁) and said second charging current (I₂).

7. The battery pack (200, 200C, 700) of claim 1 or 2, wherein said first switch circuit (CET1-DET1) allows a first discharging current (I₄) of said first battery (BAT1) to flow through when said first switch circuit (CET1-DET1) is turned on, said second switch circuit (CET2-DET2) allows a second discharging current (I₅) of said second battery (BAT2) to flow through when said second switch circuit (CET2-DET2) is turned on, wherein said second discharging current (I₅) also flows through said first battery (BAT1), and wherein said first voltage (-V_{SEN}) is indicative of a sum of said first discharging current (I₄) and said second discharging current (I₅).

8. The battery pack (200, 200C, 700) of any of claims 1 to 7, wherein said first detection circuit (608) compares said first voltage (V_{SEN}; -V_{SEN}) with a preset reference (Vcoci; V_{DOC1}), and provides a result of the comparison to said control circuit (614), and wherein if said first voltage (V_{SEN}; -V_{SEN}) is greater than said preset reference (V_{COC1};V_{DOC1}) for a time interval that is greater than a preset time interval, then said control circuit (614) determines that said first battery (BAT1) is in an over-current condition, and said control circuit (614) turns off said first switch circuit (CET1-DET1) and said second switch circuit (CET2-DET2).

9. The battery pack (200, 200C, 700) of any of claims 1 to 8, further comprising:
a fourth detection circuit (610) configured to detect a status of a battery voltage of said first battery (BAT1) and provide a detection result to said control circuit (614), wherein if said detection result indicates that said battery voltage is in an abnormal condition, then said control circuit (614) turns off said first switch circuit (CET1-DET1) and said second switch circuit (CET2-DET2).

10. A method for protecting a battery pack (200, 200C, 700) comprising a first battery (BAT1) and a second battery (BAT2), wherein said method comprises:
detecting, using a detection circuit, a status of a first voltage (V_{SEN}; -V_{SEN}) across a current sensing element (R_{SEN}) that is coupled between a negative terminal (P-) of said battery pack (200, 200C, 700) and a negative electrode of said first battery (BAT1);
determining whether said first battery (BAT1) is in an abnormal condition according to said first voltage (V_{SEN}; -V_{SEN});
detecting a status of a second voltage (V_{P1}-V1; V1-V_{P1}; V_{CET1}; V_{DET1}) across a first switch circuit (CET1-DET1) in a first path (254) that is coupled between a first positive terminal (P1+) of said battery pack (200, 200C, 700) and a connection node (258) being connected to the positive electrode of the first battery (BAT1) and the negative electrode of the second battery (BAT2);
determining whether said first path (254) is in an abnormal condition according to said second voltage (V_{P1}-V1; V1-V_{P1}; V_{CET1}; V_{DET1});
detecting a status of a third voltage (V_{M}-V2; V_{P2}-V2; V_{M}-V_{P2}; V_{P2}-V_{M}) across a second switch circuit (CET2-DET2) in a second path (256) that is coupled between a second positive terminal (P2+) of said battery pack (200, 200C, 700) and a positive electrode of said second battery (BAT2);
determining whether said second battery (BAT2) is in an abnormal condition according to said third voltage (V_{M}-V2; V_{P2}-V2; V_{M}-V_{P2}; V_{P2}-V_{M}); and
controlling, using a control circuit (614) coupled to said detection circuit, said first switch circuit (CET1-DET1) and said second switch circuit (CET2-DET2), wherein said controlling comprises:
turning off said first switch circuit (CET1-DET1) and said second switch circuit (CET2-DET2) if an abnormal condition is detected in said first battery (BAT1);
turning off said first path (254) if an abnormal condition is detected in said first path (254); and
turning off said second switch circuit (CET2-DET2) if an abnormal condition is detected in said second battery (BAT2).

11. The method of claim 10, further comprising:
turning on said second switch circuit (CET2-DET2) to allow a charging current (I₃) of said second battery (BAT2) to flow through;
turning on said first switch circuit (CET1-DET1) to allow a discharging current (I₄) of said first battery (BAT1) and said charging current (I₃) of said second battery (BAT2) to flow through, wherein said second voltage (V1-V_{P1}; V_{DET1}) is indicative of a sum of said discharging current (I₄) and said charging current (I₃);
comparing said second voltage (V1-V_{P1}; V_{DET1}) with a preset reference (V_{DOC2}); and
turning off said first switch circuit (CET1-DET1) if said second voltage (V1-V_{P1}; V_{DET1}) is greater than said preset reference (V_{DOC2}) for a time interval that is greater than a preset time interval.

12. The method of claim 10, further comprising:
turning on said first switch circuit (CET1-DET1) to allow a first charging current (I₁) of said first battery (BAT1) to flow through;
turning on said second switch circuit (CET2-DET2) to allow a second charging current (I₂) of said second battery (BAT2) to flow through, wherein said second charging current (I₂) also flows through said first battery (BAT1), and wherein said first voltage (V_{SEN}) is indicative of a sum of said first charging current (I₁) and said second charging current (I₂);
comparing said first voltage (V_{SEN}) with a preset reference (Vcoci); and
turning off said first switch circuit (CET1-DET1) and said second switch circuit (CET2-DET2) if said first voltage (V_{SEN}) is greater than said preset reference (Vcoci) for a time interval that is greater than a preset time interval.

13. The method of claim 10, further comprising:
turning on said first switch circuit (CET1-DET1) to allow a first discharging current (I₄) of said first battery (BAT1) to flow through;
turning on said second switch circuit (CET2-DET2) to allow a second discharging current (I₅) of said second battery (BAT2) to flow through, wherein said second discharging current (I₅) also flows through said first battery (BAT1), and wherein said first voltage (-V_{SEN}) is indicative of a sum of said first discharging current (I₄) and said second discharging current (I₅);
comparing said first voltage (-V_{SEN}) with a preset reference (V_{DOC1}); and
turning off said first switch circuit (CET1-DET1) and said second switch circuit (CET2-DET2) if said first voltage (-V_{SEN}) is greater than said preset reference (V_{DOC1}) for a time interval that is greater than a preset time interval.

14. The method of any of claims 10 to 13, further comprising:
detecting a status of a battery voltage of said first battery (BAT1); and
turning off said first switch circuit (CET1-DET1) and said second switch circuit (CET2-DET2) if an abnormal condition is detected in said battery voltage.

## Patentansprüche

1. Batteriepack (200, 200C, 700), umfassend ein Batterieschutzsystem (202, 602, 702) zum Schützen eines Batteriepacks (200, 200C, 700), der eine erste Batterie (BAT1) und eine zweite Batterie (BAT2) umfasst, wobei das Batterieschutzsystem (202, 602, 702) umfasst:
eine erste Erfassungsschaltung (608), die konfiguriert ist für die Erfassung eines Zustands einer ersten Spannung (V_{SEN}; -V_{SEN}) über einem Stromerfassungselement (R_{SEN}) und für die Ermittlung, ob sich die erste Batterie (BAT1) der ersten Spannung (V_{SEN}; -V_{SEN}) zufolge in einem anormalen Zustand befindet, wobei das Stromerfassungselement (R_{SEN}) zwischen einen Minuspol (P-) des Batteriepacks (200, 200C, 700) und eine negative Elektrode der ersten Batterie (BAT1) geschaltet ist;
eine zweite Erfassungsschaltung (626), die konfiguriert ist für die Erfassung eines Zustands einer zweiten Spannung (V_{P1}-V1; V1-V_{P1}; V_{CET1}; V_{DET1}) über einem ersten Schaltkreis (CET1-DET1) in einem ersten Pfad (254) und für die Ermittlung, ob sich der erste Pfad (254) der zweiten Spannung (V_{P1}-V1; V1-V_{P1}; V_{CET1}; V_{DET1}) zufolge in einem anormalen Zustand befindet, wobei der erste Pfad (254) zwischen einen ersten Pluspol (P1+) des Batteriepacks (200, 200C, 700) und einen Verbindungsknoten (258), der mit der positiven Elektrode der ersten Batterie (BAT1) und der negativen Elektrode der zweiten Batterie (BAT2) verbunden ist, geschaltet ist;
eine dritte Erfassungsschaltung (620, 624), die konfiguriert ist für die Erfassung einer dritten Spannung (V_{M}-V2; V_{P2}-V2; V_{M}-V_{P2}; V_{P2}-V_{M}) über einem zweiten Schaltkreis (CET2-DET2) in einem zweiten Pfad (256) und für die Ermittlung, ob sich die zweite Batterie (BAT2) der dritten Spannung (V_{M}-V2; V_{P2}-V2; V_{M}-V_{P2}; V_{P2}-V_{M}) zufolge in einem anormalen Zustand befindet, wobei der zweite Pfad (256) zwischen einen zweiten Pluspol (P2+) des Batteriepacks (200, 200C, 700) und eine positive Elektrode des zweiten Batteriepacks (BAT2) geschaltet ist; und
eine Steuerschaltung (614), die mit der ersten Erfassungsschaltung (608), der zweiten Erfassungsschaltung (626) und der dritten Erfassungsschaltung (620, 624) gekoppelt ist, wobei die Steuerschaltung (614) derart konfiguriert ist, dass sie den ersten Schaltkreis (CET1-DET1) und den zweiten Schaltkreis (CET2-DET2) abschaltet, wenn die erste Erfassungsschaltung (608) feststellt, dass sie die erste Batterie (BAT1) in einem anormalen Zustand befindet, und derart konfiguriert ist, dass sie den ersten Schaltkreis (CET1-DET1) abschaltet, wenn die zweite Erfassungsschaltung (626) feststellt, dass sich der erste Pfad (254) in einem anormalen Zustand befindet, und derart konfiguriert ist, dass sie den zweiten Schaltkreis (CET2-DET2) abschaltet, wenn die dritte Erfassungsschaltung feststellt, dass sich die zweite Batterie (BAT2) in einem anormalen Zustand befindet, wobei das Batterieschutzsystem (202, 602, 702) mit dem Stromerfassungselement (R_{SEN}), der ersten Schaltkreis (CET1-DET1) und dem zweiten Schaltkreis (CET2-DET2) gekoppelt ist.

2. Batteriepack (200, 200C, 700) nach Anspruch 1, wobei der zweite Schaltkreis (CET2-DET2) einen Transistor (CET2, DET2) umfasst mit einem ersten Anschluss (642), einem zweiten Anschluss (644, 638) und einem Steueranschluss (630, 636), wobei die Steuerschaltung (614) den Transistor (CET2, DET2) anschaltet, indem sie den Steueranschluss (630, 636) steuert, wobei über den Transistor (CET2, DET2) ein Strom von dem ersten Anschluss (642) zu dem zweiten Anschluss (644, 638) fließt und der Transistor zwischen dem ersten Anschluss (642) und dem zweiten Anschluss (644, 638) einen Spannungsabfall (V_{M}-V2; V_{M}-V_{P2}) erzeugt und wobei die dritte Spannung (V_{M}-V2; V_{P2}-V2; V_{M}-V_{P2}; V_{P2}-V_{M}) den Spannungsabfall (V_{M}-V2; V_{M}-V_{P2}) umfasst.

3. Batteriepack (200, 200C, 700) nach Anspruch 1 oder 2, wobei der zweite Schaltkreis (CET2-DET2) einen Entladestrom (I₆) der zweiten Batterie (BAT2) hindurchfließen lässt, wenn der zweite Schaltkreis (CET2-DET2) angeschaltet wird, und dass der erste Schaltkreis (CET1-DET1) einen Ladestrom (I₁) der ersten Batterie (BAT1) und den Entladestrom (I₆) der zweiten Batterie (BAT2) hindurchfließen lässt, wenn der erste Schaltkreis (CET1-DET1) angeschaltet wird, und wobei die zweite Spannung (V_{P1}-V1; V_{CET1}) ein Hinweis auf eine Summe des Entladestroms (I₆) und des Ladestroms (I₁) ist.

4. Batteriepack (200, 200C, 700) nach Anspruch 1 oder 2, wobei der zweite Schaltkreis (CET2-DET2) einen Ladestrom (I₃) der zweiten Batterie (BAT2) hindurchfließen lässt, wenn der zweite Schaltkreis (CET2-DET2 angeschaltet wird, und wobei der erste Schaltkreis (CET1-DET1) einen Entladestrom (I₄) der ersten Batterie (BAT1) und den Ladestrom (I₃) der zweiten Batterie (BAT2) hindurchfließen lässt, wenn der erste Schaltkreis (CET1-DET1) angeschaltet wird, und wobei die zweite Spannung (V1-V_{P1}; V_{DET1}) ein Hinweis auf eine Summe des Ladestroms (I₃) und des Entladestroms (I₄) ist.

5. Batteriepack (200, 200C, 700) nach einem der Ansprüche 1 bis 4, wobei die zweite Erfassungsschaltung (626) die zweite Spannung (V_{P1}-V1; V1-V_{P1}; V_{CET1}; V_{DET1}) mit einer voreingestellten Referenz (V_{COC2}; V_{DOC2}) vergleicht und ein Ergebnis des Vergleichs an die Steuerschaltung (614) liefert und wobei, wenn die zweite Spannung (V_{P1}-V1; V1-V_{P1}; V_{CET1}; V_{DET1}) über ein Zeitintervall, das größer ist als ein voreingestelltes Zeitintervall, größer ist als die voreingestellte Referenz (V_{COC2}; V_{DOC2}), die Steuerschaltung (614) bestimmt, dass sich der erste Pfad (254) in einem Überstromzustand befindet, und die Steuerschaltung (614) den ersten Schaltkreis (CET1-DET1) abschaltet.

6. Batteriepack (200, 200C, 700) nach Anspruch 1 oder 2, wobei der erste Schaltkreis (CET1-DET1) einen ersten Ladestrom (L₁) der ersten Batterie (BAT1) hindurchfließen lässt, wenn der ersten Schaltkreis (CET1-DET1) angeschaltet wird, der zweite Schaltkreis (CET2-DET2) einen zweiten Ladestrom (I₂) der zweiten Batterie (BAT2) hindurchfließen lässt, wenn der zweiten Schaltkreis (CET2-DET2) angeschaltet wird, wobei der zweite Ladestrom (I₂) auch durch die erste Batterie (BAT1) fließt und wobei die erste Spannung (V_{SEN}) ein Hinweis ist auf eine Summe des ersten Ladestroms (I₁) und des zweiten Ladestroms (I₂) .

7. Batteriepack (200, 200C 700) nach Anspruch 1 oder 2, wobei der erste Schaltkreis (CET1-DET1) einen ersten Entladestrom (I₄) der ersten Batterie (BAT1) hindurchfließen lässt, wenn der erste Schaltkreis (CET1-DET1) angeschaltet wird, der zweite Schaltkreis (CET2-DET2) einen zweiten Entladestrom (I₅) der zweiten Batterie (BAT2) hindurchfließen lässt, wenn der zweite Schaltkreis (CET2-DET2) angeschaltet wird, wobei der zweite Entladestrom (I₅) auch durch die erste Batterie (BAT1) fließt, und wobei die erste Spannung (-V_{SEN}) ein Hinweis ist auf eine Summe des ersten Entladestroms (I₄) und des zweiten Entladestroms (I₅).

8. Batteriepack (200, 200C, 700) nach einem der Ansprüche 1 bis 7, wobei die erste Erfassungsschaltung (608) die erste Spannung (V_{SEN}; -V_{SEN}) mit einer voreingestellten Referenz (V_{COC1}; V_{DOC1}) vergleicht und ein Ergebnis des Vergleichs an die Steuerschaltung (614) liefert und wobei, wenn die erste Spannung (V_{SEN}; -V_{SEN}) über ein Zeitintervall, das größer ist als ein voreingestelltes Zeitintervall, größer ist als die voreingestellte Referenz (V_{COC1}; V_{DOC1}), die Steuerschaltung (614) bestimmt, dass sich die erste Batterie (BAT1) in einem Überstromzustand befindet, und die Steuerschaltung (614) den ersten Schaltkreis (CET1-DET1) und den zweiten Schaltkreis (CET2-DET2) abschaltet.

9. Batteriepack (200, 200C, 700) nach einem der Ansprüche 1 bis 8, ferner umfassend:
eine vierte Erfassungsschaltung (610), die konfiguriert ist für die Erfassung eines Zustands einer Batteriespannung der ersten Batterie (BAT1) und für die Lieferung eines Ergebnisses der Erfassung an die Steuerschaltung (614), wobei, wenn das Ergebnis der Erfassung anzeigt, dass sich die Batteriespannung in einem anormalen Zustand befindet, die Steuerschaltung (614) den ersten Schaltkreis (CET1-DET1) und den zweiten Schaltkreis (CET2-DET2) abschaltet.

10. Verfahren zum Schützen eines Batteriepacks (200, 200C, 700) mit einer ersten Batterie (BAT1) und einer zweiten Batterie (BAT2), wobei das Verfahren umfasst:
Erfassen eines Zustands einer ersten Spannung (V_{SEN}; -V_{SEN}) über einem Stromerfassungselement (R_{SEN}), das zwischen einen Minuspol (P-) des Batteriepacks (200, 200C, 700) und eine negative Elektrode der ersten Batterie (BAT1) geschaltet ist, mittels einer Erfassungsschaltung;
Ermitteln, ob sich die erste Batterie (BAT1) der ersten Spannung (V_{SEN}; -V_{SEN}) zufolge in einem anormalen Zustand befindet;
Erfassen eines Zustands einer zweiten Spannung (V_{P1}-V1; V1-V_{P1}; V_{CET1}; V_{DET1}) über einem ersten Schaltkreis (CET1-DET1) in einem ersten Pfad (254), der zwischen einen ersten Pluspol (P1+) des Batteriepacks (200, 200C, 700) und einen Verbindungsknoten (258), der mit der positiven Elektrode der ersten Batterie (BAT1) und der negativen Elektrode der zweiten Batterie (BAT2) verbunden ist, geschaltet ist;
Ermitteln, ob sich der erste Pfad (254) der zweiten Spannung (V_{P1}-V1; V1-V_{P1}; V_{CET1}; V_{DET1}) zufolge in einem anormalen Zustand befindet,
Ermitteln eines Zustands einer dritten Spannung(V_{M}-V2; V_{P2}-V2; V_{M-VP2}; V_{P2}-V_{M}) über einem zweiten Schaltkreis (CET2-DET2) in einem zweiten Pfad (256), der zwischen einen zweiten Pluspol (P2+) des Batteriepacks (200, 200C, 700) und eine positive Elektrode der zweiten Batterie (BAT2) geschaltet ist;
Ermitteln, ob sich die zweite Batterie (BAT2) der dritten Spannung (V_{M}-V2; V_{P2}-V2; V_{M-VP2}; V_{P2}-V_{M}) zufolge in einem anormalen Zustand befindet; und
Steuern des ersten Schaltkreises (CET1-DET1) und des zweiten Schaltkreises (CET2-DET2) mittels einer Steuerschaltung (614), die mit der Erfassungsschaltung gekoppelt ist, wobei die Steuerung umfasst:
Abschalten der ersten Steuerschaltung (CET1-DET1) und der zweiten Steuerschaltung (CET2-DET2), wenn in der ersten Batterie (BAT1) ein anormaler Zustand erfasst wird;
Abschalten des ersten Pfads (254), wenn in dem ersten Pfad (254) ein anormaler Zustand erfasst wird; und
Abschalten des zweiten Schaltkreises (CET2-DET2), wenn in der zweiten Batterie (BAT2) ein anormaler Zustand erfasst wird.

11. Verfahren nach Anspruch 10, ferner umfassend:
Anschalten des zweiten Schaltkreises (CET2-DET2), um einen Ladestrom (I₃) der zweiten Batterie (BAT2) hindurchfließen zu lassen;
Anschalten des ersten Schaltkreises (CET1-DET1), um einen Entladestrom (I₄) der ersten Batterie (BAT1) und den Ladestrom (I₃) der zweiten Batterie (BAT2) hindurchfließen zu lassen, wobei die zweite Spannung (V1-V_{P1}; V_{DET1}) ein Hinweis ist auf ein Summe des Entladestroms (I₄) und des Ladestroms (I₃);
Vergleichen der zweiten Spannung (V1-V_{P1}; V_{DET1}) mit einer voreingestellten Referenz (V_{DOC2}); und
Abschalten des ersten Schaltkreises (CET1-DET1), wenn die zweite Spannung (V1-V_{P1}; V_{DET1}) über ein Zeitintervall, das größer ist als ein voreingestelltes Zeitintervall, größer ist als die voreingestellte Referenz (V_{DOC2}).

12. Verfahren nach Anspruch 10, ferner umfassend:
Anschalten des ersten Schaltkreises (CET1-DET1), um einen ersten Ladestrom (I₁) der ersten Batterie (BAT1) hindurchfließen zu lassen;
Anschalten des zweiten Schaltkreises (CET2-DET2), um einen zweiten Ladestrom (I₂) der zweiten Batterie (BAT2) hindurchfließen zu lassen, wobei der zweite Ladestrom (I₂) auch durch die erste Batterie (BAT1) fließt und wobei die erste Spannung (V_{SEN}) ein Hinweis ist auf eine Summe des ersten Ladestroms (I₁) und des zweiten Ladestroms (I₂); Vergleichen der ersten Spannung (V_{SEN}) mit einer voreingestellten Referenz (V_{COC1}); und
Abschalten des ersten Schaltkreises (CET1-DET1) und des zweiten Schaltkreises (CET2-DET2), wenn die erste Spannung (V_{SEN}) über ein Zeitintervall, das größer ist als ein voreingestelltes Zeitintervall, größer ist als die voreingestellte Referenz (V_{COC1}).

13. Verfahren nach Anspruch 10, ferner umfassend:
Anschalten des ersten Schaltkreises (CET1-DET1), um einen ersten Entladestrom (I₄) der ersten Batterie (BAT1) hindurchfließen zu lassen;
Anschalten des zweiten Schaltkreises (CET2-DET2), um einen zweiten Entladestrom (I₅) der zweiten Batterie (BAT2) hindurchfließen zu lassen, wobei der zweite Entladestrom (I₅) auch durch die erste Batterie (BAT1) fließt und wobei die erste Spannung (-V_{SEN}) ein Hinweis ist auf eine Summe des ersten Entladestroms (I₄) und des zweiten Entladestroms (I₅); Vergleichen der ersten Spannung (-V_{SEN}) mit einer voreingestellten Referenz (V_{DOC1}); und
Abschalten des ersten Schaltkreises (CET1-DET1) und des zweiten Schaltkreises (CET2-DET2), wenn die erste Spannung (- V_{SEN}) über ein Zeitintervall, das größer ist als ein voreingestelltes Zeitintervall, größer ist als die voreingestellte Referenz (V_{DOC1}).

14. Verfahren nach einem der Ansprüche 10 bis 13, ferner umfassend:
Erfassen eines Zustands einer Batteriespannung der ersten Batterie (BAT1); und
Abschalten des ersten Schaltkreises (CET1-DET1) und des zweiten Schaltkreises (CET2-DET2), wenn in der Batteriespannung einer anormaler Zustand erfasst wird.

## Revendications

1. Bloc de batteries (200, 200C, 700) comprenant un système de protection de batterie (202, 602, 702) pour protéger un bloc de batteries (200, 200C, 700) comprenant une première batterie (BAT1) et une seconde batterie (BAT2), dans lequel le système de protection de batterie (202, 602, 702) comprend:
un premier circuit de détection (608) configuré pour détecter un état d'une première tension (V_{SEN}; -V_{SEN}) à travers d'un élément de détection de courant (R_{SEN}) et pour déterminer si la première batterie (BAT1) est dans un état anormal d'après la première tension (V_{SEN}; -V_{SEN}), l'élément de détection de courant (R_{SEN}) étant connecté entre une borne négative (P-) du bloc de batteries (200, 200C, 700) et une électrode négative de la première batterie (BAT1);
un deuxième circuit de détection (626) configuré pour détecter un état d'une deuxième tension (V_{P1}-V1; V1-V_{P1}; V_{CET1}; V_{DET1}) à travers d'un premier circuit de commutation (CET1-DET1) dans un premier chemin (254) et pour déterminer si le premier chemin (254) se trouve dans un état anormal d'après la deuxième tension (V_{P1}-V1; V1-V_{P1}; V_{CET1}; V_{DET1}), le premier chemin (254) étant connecté entre une première borne positive (P1+) du bloc de batteries (200, 200C, 700) et un noeud de connexion (258) connecté à l'électrode positive de la première batterie (BAT1) et à l'électrode négative de la seconde batterie (BAT2);
un troisième circuit de détection (620, 624) configuré pour détecter une troisième tension (V_{M}-V2 ; V_{P2}-V2 ; V_{M}-V_{P2} ; V_{P2}-V_{M}) à travers un deuxième circuit de commutation (CET2-DET2) dans un deuxième chemin (256) et pour déterminer si la deuxième batterie (BAT2) est dans un état anormal d'après la troisième tension (V_{M}-V2 ; V_{P2}-V2 ; V_{M}-V_{P2}; V_{P2}-V_{M}), le deuxième chemin (256) étant connecté entre une deuxième borne positive (P2+) du bloc de batteries (200, 200C, 700) et une électrode positive de la deuxième batterie (BAT2); et
un circuit de commande (614) couplé au premier circuit de détection (608), au deuxième circuit de détection (626) et au troisième circuit de détection (620, 624), le circuit de commande (614) étant configuré pour désactiver le premier circuit de commutation (CET1-DET1) et le deuxième circuit de commutation (CET2-DET2) lorsque le premier circuit de détection (608) détecte que la première batterie (BAT1) est dans un état anormal, et configuré pour désactiver le premier circuit de commutation (CET1-DET1) lorsque le deuxième circuit de détection (626) détecte que le premier chemin (254) est dans un état anormal, et configuré pour désactiver le deuxième circuit de commutation (CET2-DET2) lorsque le troisième circuit de détection détecte que la deuxième batterie (BAT2) est dans un état anormal,
le système de protection de batterie (202, 602, 702) étant couplé à l'élément de détection de courant (R_{SEN}), au premier circuit de commutation (CET1-DET1) et au deuxième circuit de commutation (CET2-DET2).

2. Bloc de batteries (200, 200C, 700) selon la revendication 1, dans lequel le deuxième circuit de commutation (CET2-DET2) comprend un transistor (CET2, DET2) ayant une première borne (642), une deuxième borne (644, 638) et une borne de commande (630, 636), dans lequel le circuit de commande (614) allume le transistor (CET2, DET2), en commandant la borne de commande (630, 636), dans lequel un courant circule à travers le transistor (CET2, DET2) de la première borne (642) à la deuxième borne (644, 638) et le transistor produit une chute de tension (V_{M}-V2; V_{M}-V_{P2}) entre la première borne (642) et la deuxième borne (644, 638) et dans lequel la troisième tension (V_{M}-V2; V_{P2}-V2; V_{M}-V_{P2}; V_{P2}-V_{M}) comprend la chute de tension (V_{M}-V2 ; V_{M}-V_{P2}).

3. Bloc de batteries (200, 200C, 700) selon la revendication 1 ou 2, dans lequel le deuxième circuit de commutation (CET2-DET2) permet le passage d'un courant de décharge (I₆) de la deuxième batterie (BAT2) lorsque le deuxième circuit de commutation (CET2-DET2) est activé, et en ce que le premier circuit de commutation (CET1-DET1) permet le passage d'un courant de charge (I₁) de la première batterie (BAT1) et le courant de décharge (I₆) de la deuxième batterie (BAT2) lorsque le premier circuit de commutation (CET1-DET1) est activé, et dans lequel la deuxième tension (V_{P1}-V1; V_{CET1}) est une indication d'une somme du courant de décharge (I₆) et du courant de charge (I₁).

4. Bloc de batteries (200, 200C, 700) selon la revendication 1 ou 2, dans lequel le deuxième circuit de commutation (CET2-DET2) permet le passage d'un courant de charge (I₃) de la deuxième batterie (BAT2) lorsque le deuxième circuit de commutation (CET2-DET2) est activé, et dans lequel le premier circuit de commutation (CET1-DET1) permet le passage d'un courant de décharge (I₄) de la première batterie (BAT1) et le courant de charge (I₃) de la deuxième batterie (BAT2) lorsque le premier circuit de commutation (CET1-DET1) est activé, et dans lequel la deuxième tension (V1-V_{P1} ; V_{DET1}) est une indication d'une somme du courant de charge (I₃) et du courant de décharge (I₄).

5. Bloc de batteries (200, 200C, 700) selon l'une quelconque des revendications 1 à 4, dans lequel le deuxième circuit de détection (626) compare la deuxième tension (V_{P1}-V1; V1-V_{P1}; V_{CET1}; VD_{ET1}) à une référence prédéfinie (V_{COC2}; V_{DOC2}) et fournit un résultat de la comparaison au circuit de commande (614) et dans lequel, lorsque la deuxième tension (V_{P1}-V1; V1-V_{P1}; V_{CET1}; V_{DET1}) est supérieure à la référence prédéfinie (V_{COC2}; V_{DOC2}) pendant un intervalle de temps supérieur à un intervalle de temps prédéfinie, le circuit de commande (614) détermine que le premier chemin (254) est dans un état de surintensité, et le circuit de commande (614) désactive le premier circuit (CET1-DET1).

6. Bloc de batteries (200, 200C, 700) selon la revendication 1 ou 2, dans lequel, lorsque le premier circuit de commutation (CET1-DET1) permet le d'un un premier courant de charge (L₁) de la première batterie (BAT1), lorsque le premier circuit de commutation (CET1-DET1) est activé, le deuxième circuit de commutation (CET2-DET2) permet le passage d'un deuxième courant de charge (I₂) de la deuxième batterie (BAT2), lorsque le deuxième circuit de commutation (CET2-DET2) est activé, le deuxième courant de charge (I₂) passant également à travers la première batterie (BAT1), et la première tension (V_{SEN}) étant une indication d'une somme du premier courant de charge (I₁) et du deuxième courant de charge (I₂).

7. Bloc de batteries (200, 200C, 700) selon la revendication 1 ou 2, dans lequel, lorsque le premier circuit (CET1-DET1) est activé, le premier circuit (CET1-DET1) permet le passage d'un premier courant de décharge (I₄) de la première batterie (BAT1), lorsque le premier circuit de commutation (CET1-DET1) est activé, le deuxième circuit (CET2-DET2) permet le passage d'un deuxième courant de décharge (I₅) de la deuxième batterie (BAT2), lorsque le deuxième circuit de commutation (CET2-DET2) est activé, le deuxième courant de décharge (I₅) passant également à travers la première batterie (BAT1), et la première tension (-V_{SEN}) étant une indication d'une somme du premier courant de décharge (I₄) et du deuxième courant de décharge (I₅).

8. Bloc de batteries (200, 200C, 700) selon l'une quelconque des revendications 1 à 7, dans lequel le premier circuit de détection (608) compare la première tension (V_{SEN}; -V_{SEN}) à une référence prédéfinie (V_{COC1}; V_{DOC1}) et fournit un résultat de la comparaison au circuit de commande (614) et dans lequel, lorsque la première tension (V_{SEN}; -V_{SEN}) est supérieure à la référence prédéfinie (V_{COC1}; V_{DOC1}) pendant un intervalle de temps supérieur à un intervalle de temps prédéfini, le circuit de commande (614) détermine que la première batterie (BAT1) est dans un état de surintensité, et le circuit de commande (614) désactive le premier circuit de commutation (CET1-DET1) et le deuxième circuit de commutation (CET2-DET2).

9. Bloc de batteries (200, 200C, 700) selon l'une quelconque des revendications 1 à 8, comprenant en outre:
un quatrième circuit de détection (610) configuré pour détecter un état d'une tension de batterie de la première batterie (BAT1) et pour fournir un résultat de la détection au circuit de commande (614), dans lequel, si le résultat de la détection indique que la tension de batterie est dans un état anormal, le circuit de commande (614) désactive le premier circuit de commutation (CET1-DET1) et le deuxième circuit de commutation (CET2-DET2).

10. Procédé de protection d'un bloc de batteries (200, 200C, 700) comprenant une première batterie (BAT1) et une seconde batterie (BAT2), le procédé comprenant:
détecter un état d'une première tension (V_{SEN}; -V_{SEN}) à travers d'un élément de détection de courant (R_{SEN}) connecté entre une borne négative (P-) du bloc de batteries (200, 200C, 700) et une électrode négative de la première batterie (BAT1) au moyen d'un circuit de détection;
déterminer si la première batterie (BAT1) est dans un état anormal d'après la première tension (V_{SEN}; -V_{SEN}) ; détecter un état d'une seconde tension (V_{P1}-V1; V1-V_{P1}; V_{CET1}; V_{DET1}) à travers un premier circuit (CET1-DET1) dans un premier chemin (254) connecté entre une première borne positive (P1+) du bloc de batteries (200, 200C, 700) et un noeud de connexion (258) connecté à l'électrode positive de la première batterie (BAT1) et à l'électrode négative de la seconde batterie (BAT2);
déterminer si le premier chemin (254) est dans un état anormal d'après la deuxième tension (V_{P1}-V1; V1-V_{P1}; V_{CET1}; V_{DET1}),
détecter un état d'une troisième tension (V_{M}-V2; V_{P2}-V2; V_{M}-V_{P2}; V_{P2}-V_{M}) à travers un deuxième circuit (CET2-DET2) dans un deuxième chemin (256) connecté entre une deuxième borne positive (P2+) du bloc de batteries (200, 200C, 700) et une électrode positive de la deuxième batterie (BAT2);
déterminer si la deuxième batterie (BAT2) est dans un état anormal d'après la troisième tension (V_{M}-V2; V_{P2}-V2; V_{M}-V_{P2}; V_{P2}-V_{M}) ; et
commander le premier circuit de commutation (CET1-DET1) et le deuxième circuit de commutation (CET2-DET2) au moyen d'un circuit de commande (614) couplé au circuit de détection, la commande comprenant:
désactiver le premier circuit de commande (CET1-DET1) et le deuxième circuit de commande (CET2-DET2) lorsqu'une condition anormale est détectée dans la première batterie (BAT1);
désactiver le premier chemin (254) lorsqu'une condition anormale est détectée dans le premier chemin (254); et
désactiver le deuxième circuit de commutation (CET2-DET2) lorsqu'un état anormal est détecté dans la deuxième batterie (BAT2).

11. Procédé selon la revendication 10, comprenant en outre:
activer le deuxième circuit de commutation (CET2-DET2) pour permettre le passage d'un courant de charge (I₃) de la deuxième batterie (BAT2);
activer le premier circuit de commutation (CET1-DET1) pour permettre le passage d'un courant de décharge (I₄) de la première batterie (BAT1) et le courant de charge (I₃) de la deuxième batterie (BAT2), la deuxième tension (V1-V_{P1}; V_{DET1}) étant une indication d'une somme du courant de décharge (I₄) et du courant de charge (I₃);
comparer la deuxième tension (V1-V_{P1}; V_{DET1}) à une référence prédéfinie (V_{DOC2}); et
désactiver le premier circuit (CET1-DET1) si la deuxième tension (V1-V_{P1}; V_{DET1}) est supérieure à la référence prédéfinie (V_{DOC2}) pendant un intervalle de temps supérieur à un intervalle de temps prédéfinie.

12. Procédé selon la revendication 10, comprenant en outre:
activer le premier circuit de commutation (CET1-DET1) pour permettre le passage d'un premier courant de charge (I₁) de la première batterie (BAT1);
activer le deuxième circuit (CET2-DET2) pour permettre le passage d'un deuxième courant de charge (I₂) de la deuxième batterie (BAT2), le deuxième courant de charge (I₂) passant également à travers de la première batterie (BAT1) et la première tension (V_{SEN}) étant une indication d'une somme du premier courant de charge (I₁) et du deuxième courant de charge (I₂);
comparer la première tension (V_{SEN}) à une référence prédéfinie (V_{COC1}); et
désactiver le premier circuit de commutation (CET1-DET1) et
le deuxième circuit de commutation (CET2-DET2) si la première tension (V_{SEN}) est supérieure à la référence prédéfinie (V_{COC1}) pendant un intervalle de temps supérieur à un intervalle de temps prédéfini.

13. Procédé selon la revendication 10, comprenant en outre:
activer le premier circuit de commutation(CETl-DETl) pour permettre le passage d'un premier courant de décharge (I₄) de la première batterie (BAT1);
activer le deuxième circuit de commutation (CET2-DET2) pour permettre le passage d'un deuxième courant de décharge (I₅) de la deuxième batterie (BAT2), le deuxième courant de décharge (I₅) passant également à travers la première batterie (BAT1), et la première tension (-V_{SEN}) étant une indication d'une somme du premier courant de décharge (I₄) et
du deuxième courant de décharge (I₅);
comparer la première tension (-_{VSEN}) à une référence prédéfinie (V_{DOC1}); et
désactiver le premier circuit de commutation (CET1-DET1) et le deuxième circuit de commutation (CET2-DET2) lorsque la première tension (-V_{SEN}) est supérieure à la référence prédéfinie (V_{DOC1}) pendant un intervalle de temps supérieur à un intervalle de temps prédéfini.

14. Procédé selon l'une quelconque des revendications 10 à 13, comprenant en outre:
détecter un état d'une tension de batterie de la première batterie (BAT1); et
désactiver le premier circuit de commutation (CET1-DET1) et le deuxième circuit de commutation (CET2-DET2) lorsqu'un état anormal est détecté dans la tension de la batterie.
